# EUROPÄISCHE PATENTSCHRIFT

(11) **EP 2 599 629 B1**
(45) Veröffentlichungstag und Bekanntmachung des Hinweises auf die Patenterteilung: **05.04.2017**
(21) Anmeldenummer: 12187610.6
(22) Anmeldetag: 08.10.2012
(51) Int. Cl.: B32B 27/34

(54) **Verwendung einer Mehrschichtfolie für die Herstellung photovoltaischer Module**
Use of a multilayered film for the production of photovoltaic modules
Utilisation d'une feuille multicouche pour la fabrication de modules photovoltaïques

(30) Priorität: 14.10.2011 DE 102011084519
(43) Veröffentlichungstag der Anmeldung: 05.06.2013
(73) Patentinhaber: Evonik Degussa GmbH, 45128 Essen (DE)
(72) Erfinder: Pawlik, Andreas, 45657 Recklinghausen (DE); Wielpütz, Martin, 48308 Senden (DE); Beyer, Michael, 46348 Raesfeld (DE)

(56) Entgegenhaltungen:
- EP-A1- 1 884 356

## Beschreibung

Die Erfindung betrifft die Verwendung einer Mehrschichtfolie mit haftverbessernder Additivierung als Rückabdeckung für Solarmodule.

Solarmodule, häufig auch als photovoltaische Module bezeichnet, dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen.

Die aktive Solarzelle befindet sich hierbei zwischen einer Frontabdeckung und einer Rückabdeckung. Die Frontabdeckung ist lichtdurchlässig und besteht im Regelfall aus Glas; sie ist mittels einer Haftvermittlerschicht, die häufig aus einem EthylenVinylacetat-Copolymeren besteht, mit der die Solarzelle enthaltenden Schicht verbunden. Die Rückabdeckung garantiert elektrische Abschirmung und dient als Schutz gegen Witterungseinflüsse, wie UV-Licht, und als Feuchtigkeitsbarriere.

Für die Rückabdeckung werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems. Allerdings weisen derartige Fluorpolymerfolien nur eine geringe Haftung zur Siegelschicht auf, die als Einbettungsmaterial für die Solarzellen selbst verwendet wird. Darüber hinaus trägt die Fluorpolymerfolie nur in untergeordnetem Maß zur elektrischen Isolierung bei, woraus die Notwendigkeit der Verwendung einer vergleichsweise dicken Polyesterfolie resultiert.

In der WO 2008138022 wird daher vorgeschlagen, bei derartigen Verbunden die beiden Fluorpolymerfolien durch Folien aus Polyamid 12 (PA12) zu ersetzen. In einer Weiterbildung hiervon wird in der WO 2011066595 vorgeschlagen, dass die der Solarzelle zugewandte Thermoplastschicht einen Licht reflektierenden Füllstoff wie Titandioxid enthält, während die der Solarzelle abgewandte Thermoplastschicht einen zweiten Füllstoff, wie Glasfasern, Wollastonit oder Glimmer enthält, der eine höhere Wärmeleitfähigkeit dieser Schicht bewirkt. Beispielhafte Thermoplaste entstammen der Gruppe der Polyamide, Polyester oder Blends aus Polyamid und Polyolefin. Explizit genannt werden PA11, PA12 und PA1010 sowie deren Blends mit Polyolefinen.

Derartige Photovoltaikmodule haben Standzeiten von mindestens 20 Jahren. Während dieses Zeitraums muss die interlaminare Haftung möglichst erhalten bleiben. Dies gilt einerseits für die Anbindung der Rückfolie an die die eigentliche Solarzelle enthaltende Siegelschicht und andererseits auch für die Haftung der einzelnen Schichten der Rückfolie untereinander. Wenn im Polymeranteil der Rückfolie in allen Schichten das gleiche Polyamid eingesetzt wird, wird im Regelfall eine sehr gute Haftung erzielt. Oftmals besteht der Polymeranteil der Mittelschicht jedoch aus Kostengründen aus Blends von Polyamiden und Polyolefinen. Derartige Verbunde können, bedingt durch den Polyolefinanteil, über ein niedrigeres Haftungsausgangsniveau verfügen, insbesondere aber sinkt das Haftungsniveau, verglichen mit reinen Polyamidsystemen, zeitabhängig stärker.

Die Aufgabe der Erfindung ist daher, in Rückfolien von Photovoltaikmodulen die Haftung zwischen rein polyamidbasierten Schichten und solchen, die Polyamid und Polyolefin enthalten, zu verbessern.

In der EP 1 884 356 A1 wird ein Mehrschichtverbund in Form eines extrudierten Hohlprofils beschrieben, bei dem die Außenschicht aus einer Mischung auf Basis eines Polyamids und eines Polyamidelastomers besteht, was bei höheren Extrusionsgeschwindigkeiten zu einer höheren Reißdehnung führt. Diese Hohlprofile finden Anwendung als Leitungen im Kraftfahrzeugbereich.

Überraschend wurde gefunden, dass die zugrundeliegende Aufgabe durch den Einsatz von Polyamidelastomeren vom Typ Polyetheresteramid oder Polyetheramid gelöst werden kann.

Gegenstand der Erfindung ist daher eine Folie, die folgende Schichten enthält:
a) Eine erste Außenschicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
b) eine Mittelschicht aus einer Formmasse, die zu mindestens 50 Gew.-%, bevorzugt zu mindestens 55 Gew.-% und besonders bevorzugt zu mindestens 60 Gew.-%, jeweils bezogen auf die gesamte Formmasse, einen Polymeranteil enthält, der aus folgenden Komponenten besteht:
   I. 30 bis 95 Gew.-Teile, bevorzugt 35 bis 90 Gew.-Teile und besonders bevorzugt 40 bis 85 Gew.-Teile Polyamid und
   II. 5 bis 70 Gew.-Teile, bevorzugt 10 bis 65 Gew.-Teile und besonders bevorzugt 15 bis 60 Gew.-Teile Polyolefin, wobei die Summe der Gew.-Teile 100 ergibt, sowie
c) eine zweite Außenschicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
   wobei die Schichten gemäß a), b) und c) direkt aufeinanderfolgen und wobei eine Haftungsmodifizierung des Folienverbundes durch eine Maßnahme erfolgt, die ausgewählt ist aus
   1. Einsatz eines Polyamidelastomeren, ausgewählt aus Polyetheresteramid und Polyetheramid, als Polyamidkomponente in der Formmasse der Schicht gemäß a) derart, dass die Formmasse der Schicht gemäß a) 1 bis 25 Gew.-% und bevorzugt 2 bis 20 Gew.-% an Polyamidelastomer enthält;
   2. Einsatz eines Polyamidelastomeren, ausgewählt aus Polyetheresteramid und Polyetheramid, als Polyamidkomponente in der Formmasse der Schicht gemäß b) derart, dass die Formmasse der Schicht gemäß b) 1 bis 15 Gew.-% und besonders bevorzugt 2 bis 10 Gew.-% an Polyamidelastomer enthält; und
   3. Einsatz eines Polyamidelastomeren, ausgewählt aus Polyetheresteramid und Polyetheramid, als Polyamidkomponente in der Formmasse der Schicht gemäß c) derart, dass die Formmasse der Schicht gemäß c) 1 bis 25 Gew.-% und bevorzugt 2 bis 20 Gew.-% an Polyamidelastomer enthält,
   wobei die Prozentangaben unter 1., 2. und 3. auf die jeweilige Formmasse bezogen sind.

Es sind also verschiedene Ausführungsformen möglich:
In einer ersten Ausführungsform ist nur in der Schicht gemäß a) Polyamidelastomer enthalten.

In einer zweiten Ausführungsform ist nur in der Schicht gemäß b) Polyamidelastomer enthalten.

In einer dritten Ausführungsform ist nur in der Schicht gemäß c) Polyamidelastomer enthalten.

In einer vierten Ausführungsform ist sowohl in der Schicht gemäß a) als auch in der Schicht gemäß c) Polyamidelastomer enthalten.

In einer fünften Ausführungsform ist sowohl in der Schicht gemäß a) als auch in der Schicht gemäß b) Polyamidelastomer enthalten.

In einer sechsten Ausführungsform ist sowohl in der Schicht gemäß b) als auch in der Schicht gemäß c) Polyamidelastomer enthalten.

In einer siebten Ausführungsform ist sowohl in der Schicht gemäß a) als auch in den Schichten gemäß b) und c) Polyamidelastomer enthalten.

Die folgenden näheren Ausführungen gelten, sofern nichts anderes angegeben ist, für alle diese Ausführungsformen gleichermaßen.

Das Polyamid kann ein teilkristallines Polyamid sein wie beispielsweise PA6, PA66, PA610, PA612, PA10, PA810, PA106, PA1010, PA11, PA1011, PA1012, PA1210; PA1212, PA814, PA1014, PA618, PA512, PA613, PA813, PA914, PA1015, PA11, PA12 oder ein teilaromatisches Polyamid, ein sogenanntes Polyphthalamid (PPA). (Die Kennzeichnung der Polyamide entspricht internationaler Norm, wobei die erste(n) Ziffer(n) die C-Atomzahl des Ausgangsdiamins und die letzte(n) Ziffer(n) die C-Atomzahl der Dicarbonsäure angeben. Wird nur eine Zahl genannt, so bedeutet dies, dass von einer α,ω-Aminocarbonsäure bzw. von dem davon abgeleiteten Lactam ausgegangen worden ist; im übrigen sei verwiesen auf H. Domininghaus, Die Kunststoffe und ihre Eigenschaften, Seiten 272 ff., VDI-Verlag, 1976.) Geeignete PPAs sind beispielsweise PA66/6T, PA6/6T, PA6T/MPMDT (MPMD steht für 2-Methylpentamethylendiamin), PA9T, PA10T, PA11T, PA12T, PA14T sowie Copolykondensate dieser letzten Typen mit einem aliphatischen Diamin und einer aliphatischen Dicarbonsäure oder mit einer ω-Aminocarbonsäure bzw. einem Lactam. Teilkristalline Polyamide besitzen eine Schmelzenthalpie von mehr als 25 J/g, gemessen mit der DSC-Methode gemäß ISO 11357 beim 2. Aufheizen und Integration des Schmelzpeaks.

Das Polyamid kann aber auch ein semikristallines Polyamid sein. Semikristalline Polyamide besitzen eine Schmelzenthalpie von 4 bis 25 J/g, gemessen mit der DSC-Methode gemäß ISO 11357 beim 2. Aufheizen und Integration des Schmelzpeaks. Beispiele für geeignete semikristalline Polyamide sind
- Das Polyamid aus 1,10-Decandisäure oder 1,12-Dodecandisäure und 4,4'-Diaminodicyclohexylmethan (PA PACM10 und PA PACM12), ausgehend von einem 4,4'-Diaminodicyclohexylmethan mit einem trans,trans-Isomerenanteil von 35 bis 65 %;
- Copolymere auf Basis der obengenannten teilkristallinen Polyamide; sowie
- Blends aus den obengenannten teilkristallinen Polyamiden und einem damit verträglichen amorphen Polyamid.

Das Polyamid kann auch ein amorphes Polyamid sein. Amorphe Polyamide besitzen eine Schmelzenthalpie von weniger als 4 J/g, gemessen mit der DSC-Methode gemäß ISO 11357 beim 2. Aufheizen und Integration des Schmelzpeaks. Beispiele für amorphe Polyamide sind:
- das Polyamid aus Terephthalsäure und/oder Isophthalsäure und dem Isomerengemisch aus 2.2.4- und 2.4.4-Trimethylhexamethylendiamin,
- das Polyamid aus Isophthalsäure und 1.6-Hexamethylendiamin,
- das Copolyamid aus einem Gemisch aus Terephthalsäure/Isophthalsäure und 1.6-Hexamethylendiamin, gegebenenfalls in Mischung mit 4.4'-Diaminodicyclohexylmethan,
- das Copolyamid aus Terephthalsäure und/oder Isophthalsäure, 3.3'-Dimethyl-4.4'-diaminodicyclohexylmethan und Laurinlactam oder Caprolactam,
- das (Co)Polyamid aus 1.12-Dodecandisäure oder Sebacinsäure, 3.3'-Dimethyl-4.4'-diaminodicyclohexylmethan und gegebenenfalls Laurinlactam oder Caprolactam,
- das Copolyamid aus Isophthalsäure, 4.4'-Diaminodicyclohexylmethan und Laurinlactam oder Caprolactam,
- das Polyamid aus 1.12-Dodecandisäure und 4.4'-Diaminodicyclohexylmethan (bei niedrigem trans,trans-Isomerenanteil),
- das (Co)Polyamid aus Terephthalsäure und/oder Isophthalsäure sowie einem alkylsubstituierten Bis(4-aminocyclohexyl)methan-Homologen, gegebenenfalls in Mischung mit Hexamethylendiamin,
- das Copolyamid aus Bis(4-amino-3-methyl-5-ethyl-cyclohexyl)methan, gegebenenfalls zusammen mit einem weiteren Diamin, sowie Isophthalsäure, gegebenenfalls zusammen mit einer weiteren Dicarbonsäure,
- das Copolyamid aus einer Mischung von m-Xylylendiamin und einem weiteren Diamin, z. B. Hexamethylendiamin, sowie Isophthalsäure, gegebenenfalls zusammen mit einer weiteren Dicarbonsäure wie z. B. Terephthalsäure und/oder 2,6-Naphthalindicarbonsäure,
- das Copolyamid aus einer Mischung von Bis(4-amino-cyclohexyl)methan und Bis-(4-amino-3-methyl-cyclohexyl)methan sowie aliphatischen Dicarbonsäuren mit 8 bis 14 C-Atomen, sowie
- Polyamide oder Copolyamide aus einer Mischung, die 1.14-Tetradecandisäure sowie ein aromatisches, arylaliphatisches oder cycloaliphatisches Diamin enthält.

Diese Beispiele können durch Hinzunahme weiterer Komponenten (z. B. Caprolactam, Laurinlactam oder Diamin/Dicarbonsäure-Kombinationen) oder durch teilweisen oder vollständigen Ersatz von Ausgangskomponenten durch andere Komponenten weitestgehend variiert werden.

Beim Polyolefin der Schicht gemäß b) handelt es sich beispielsweise um Polyethylen oder um Polypropylen. Grundsätzlich kann jeder handelsübliche Typ eingesetzt werden. So kommen beispielsweise in Frage: Lineares Polyethylen hoher, mittlerer oder niedriger Dichte, LDPE, isotaktisches oder ataktisches Homopolypropylen, Randomcopolymere von Propen mit Ethen und/oder Buten-1, Ethylen-Propylen-Blockcopolymere und dergleichen mehr. Das Polyolefin kann auch eine Schlagzähkomponente wie z. B. EPM- oder EPDM-Kautschuk oder SEBS enthalten; es kann nach jedem bekannten Verfahren hergestellt werden, beispielsweise nach Ziegler-Natta, nach dem Phillips-Verfahren, mittels Metallocenen oder radikalisch.

Das Polyolefin kann zur besseren Anbindung an das Polyamid funktionelle Gruppen enthalten; zusätzlich oder alternativ hierzu kann ein Verträglichkeitsvermittler zugesetzt werden. Als funktionelle Gruppen eignen sich z.B. Säureanhydridgruppen, N-Acyllactamgruppen, Carbonsäuregruppen, Epoxidgruppen, Oxazolingruppen, Trialkoxysilangruppen oder Hydroxylgruppen. Die funktionellen Gruppen können hierbei entweder durch Copolymerisation eines geeigneten Monomeren zusammen mit dem Olefin oder durch eine Pfropfreaktion eingebracht werden. Bei der Pfropfreaktion wird ein vorgebildetes Polyolefin auf bekannte Weise mit einem ungesättigten, funktionellen Monomeren und vorteilhafterweise einem Radikalspender bei erhöhter Temperatur umgesetzt.

Polyetheresteramide sind z. B. aus der DE-A-25 23 991 und der DE-A-27 12 987 bekannt; sie enthalten als Comonomer ein Polyetherdiol. Polyetheramide sind beispielsweise aus der DE-A- 30 06 961 bekannt; sie enthalten als Comonomer ein Polyetherdiamin.

Beim Polyetherdiol bzw. dem Polyetherdiamin kann die Polyethereinheit beispielsweise auf 1.2-Ethandiol, 1.2-Propandiol, 1.3-Propandiol, 1.4-Butandiol oder 1.3-Butandiol basieren. Die Polyethereinheit kann auch gemischt aufgebaut sein, etwa mit statistischer oder blockweiser Verteilung der von den Diolen herrührenden Einheiten. Das Gewichtsmittel der Molmasse der Polyetherdiole bzw. Polyetherdiamine liegt bei 200 bis 5000 g/mol und vorzugsweise bei 400 bis 3000 g/mol; ihr Anteil am Polyetheresteramid bzw. Polyetheramid beträgt bevorzugt 4 bis 60 Gew.-% und besonders bevorzugt 10 bis 50 Gew.-%. Geeignete Polyetherdiamine sind durch Konversion der entsprechenden Polyetherdiole durch reduktive Aminierung oder Kupplung an Acrylnitril mit nachfolgender Hydrierung zugänglich; sie sind z. B. in Form der JEFFAMIN^{®} D- oder ED-Typen oder der ELASTAMINE^{®}-Typen bei der Huntsman Corp. oder in Form der Polyetheramin D-Reihe bei der BASF SE kommerziell erhältlich. In geringeren Mengen kann auch ein Polyethertriamin mit verwendet werden, z. B. ein JEFFAMIN^{®} T-Typ, falls ein verzweigtes Polyetheramid eingesetzt werden soll. Vorzugsweise setzt man Polyetherdiamine bzw. Polyethertriamine ein, die pro Ethersauerstoffatom im Mittel mindestens 2,3 Kohlenstoffatome in der Kette enthalten. Erfindungsgemäß sind Polyetheramide wegen der besseren Hydrolysebeständigkeit bevorzugt.

Die Formmasse der Schicht gemäß a) kann entweder eines der obengenannten Polyamide oder mehrere als Gemisch enthalten. Weiterhin können bis zu 40 Gew.-%, bezogen auf den gesamten Polymeranteil der Formmasse, andere Thermoplaste enthalten sein, beispielsweise schlagzähmachende Kautschuke. Eventuell enthaltene Kautschuke enthalten vorzugsweise, dem Stand der Technik entsprechend, funktionelle Gruppen, mit denen eine Verträglichkeit mit der Polyamidmatrix erhalten wird. Darüber hinaus können die für Polyamide üblichen Hilfs- und Zusatzstoffe enthalten sein, insbesondere Licht- und/oder Wärmestabilisatoren, oder bevorzugt auch Licht reflektierende Füllstoffe wie beispielsweise Titandioxid (WO 2011066595).

Die Formmasse der Schicht gemäß b) kann neben Polyamid entweder eines der obengenannten Polyolefine oder mehrere als Gemisch enthalten. Darüber hinaus können die für Polyamid- und Polyolefinformmassen üblichen Hilfs- und Zusatzstoffe enthalten sein, insbesondere Licht- und/oder Wärmestabilisatoren, Licht reflektierende Füllstoffe wie beispielsweise Titandioxid sowie verstärkende Füllstoffe wie beispielsweise Glasfasern, Wollastonit oder Glimmer.

Für die Formmasse der Schicht gemäß c) gilt das Gleiche wie für die Formmasse der Schicht gemäß a) sowie hinsichtlich Füllstoffen das Gleiche wie für die Formmasse der Schicht gemäß b). Zusätzlich kann die Formmasse der Schicht gemäß c) eingefärbt sein und/oder ein Mattierungsmittel aufweisen.

Die einzelnen Folienschichten weisen in der Regel folgende Dicken auf:
- Schichten gemäß a) und c): 15 bis100 µm und vorzugsweise 25 bis 50 µm;
- Schicht gemäß b): 100 bis 500 µm und vorzugsweise 150 bis 400 µm.

Die erfindungsgemäß verwendete Mehrschichtfolie kann nach allen Methoden des Standes der Technik hergestellt werden, beispielsweise durch Coextrusion oder Laminieren.

Gegenstand der Erfindung ist auch die Verwendung der anspruchsgemäßen Folie als Rückabdeckung eines photovoltaischen Moduls. Hierzu wird die Schicht gemäß a) mit der Siegelschicht, in die die Solarzelle eingebettet ist, beispielsweise durch Laminieren oder Kleben verbunden. Wegen des Anteils an Polyamid bzw. Polyamidelastomer in der Schicht gemäß a) wird beim Laminieren eine gute Haftung zur Siegelschicht erhalten. Als Siegelschicht kann jedes gemäß dem Stand der Technik gebräuchliche Material verwendet werden.

Gegenstand der Erfindung ist darüber hinaus ein photovoltaisches Modul, das die anspruchsgemäße Mehrschichtfolie als Rückabdeckung enthält, wobei die Schicht gemäß a) mit der Siegelschicht, in die die Solarzelle eingebettet ist, verbunden ist.

Die Erfindung wird nachfolgend beispielhaft erläutert. Hierzu wurden folgende Formmassen hergestellt; bei "Teilen" handelt es sich immer um Gewichtsteile:

### Compound 1 für Außenschichten:

79,25 Teile VESTAMID^{®} L1901 nf (PA12), 0,5 Teile IRGANOX^{®} 1098 (ein sterisch gehindertes phenolisches Antioxidans), 0,2 Teile TINUVIN^{®} 312 (UV-Absorber) und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 2 für Außenschichten:

71,75 Teile VESTAMID^{®} L1901 nf, 7,5 Teile eines Polyetheresteramids (hergestellt aus 63,796 Gew.-% Laurinlactam, 6,645 Gew.-% Dodecandisäure, 29,492 Gew.-% PTHF 1000 und 0,067 Gew.-% unterphosphoriger Säure 50%ig), 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 3 für Außenschichten:

64,25 Teile VESTAMID® L1901 nf, 15 Teile des gleichen Polyetheresteramids wie im Compound 2, 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 4 für Mittelschicht:

50,6 Teile VESTAMID^{®} L1901, 26 Teile MOPLEN HP552L (Homopolypropylen, Extrusionstyp), 20 Teile Kaolin TEC 110, 3 Teile KRATON^{®} FG1901 (ein mit Maleinsäureanhydrid modifiziertes Styrol-Ethylen/Butylen-Blockcopolymer) und 0,4 Teile IRGANOX^{®} 1098 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Extrusion dreischichtiger Folien:

Mit einer Mehrschichtfolienanlage der Fa. Collin (Breitschlitzdüse 300 mm, Spalt 0-6 mm, Co-Extrusionsfeedblock für 3-schichtige bzw. 5-schichtige Folien) wurden bei einer Verarbeitungstemperatur von ca. 230 °C dreischichtige Folien hergestellt. Die Mittelschicht wurde auf 250 µm eingestellt, die Außenschichten jeweils auf 50 µm. Die Ergebnisse sind in der Tabelle 1 dargestellt.

**Tabelle 1: Beispiele**

| | Schichtaufbau | Interlaminare Haftung [N/mm] |
|---|---|---|
| Vergleichsbeispiel | Compound 1/Compound 4/Compound 1 | 2,2 |
| Beispiel 1 | Compound 2/Compound 4/Compound 2 | 3,2 |
| Beispiel 2 | Compound 3/Compound 4/Compound 3 | 3,5 |

## Patentansprüche

1. Folie, die folgende Schichten enthält:
a) Eine erste Außenschicht aus einer Formmasse, die einen Polyamidanteil von mindestens 35 Gew.-%, bezogen auf die gesamte Formmasse, enthält,
b) eine Mittelschicht aus einer Formmasse, die zu mindestens 50 Gew.-%, bezogen auf die gesamte Formmasse, einen Polymeranteil enthält, der aus folgenden Komponenten besteht:
I. 30 bis 95 Gew.-Teile Polyamid und
II. 5 bis 70 Gew.-Teile Polyolefin,
wobei die Summe der Gew.-Teile 100 ergibt, sowie
c) eine zweite Außenschicht aus einer Formmasse, die einen Polyamidanteil von mindestens 35 Gew.-%, bezogen auf die gesamte Formmasse, enthält,
wobei die Schichten gemäß a), b) und c) direkt aufeinander folgen und wobei eine Haftungsmodifizierung des Folienverbundes durch eine Maßnahme erfolgt, die ausgewählt ist aus
1. Einsatz eines Polyamidelastomeren, ausgewählt aus Polyetheresteramid und Polyetheramid, als Polyamidkomponente in der Schicht gemäß a) derart, dass die Formmasse dieser Schicht 1 bis 25 Gew.-% an Polyamidelastomer enthält;
2. Einsatz eines Polyamidelastomeren, ausgewählt aus Polyetheresteramid und Polyetheramid, als Polyamidkomponente in der Formmasse der Schicht gemäß b) derart, dass die Formmasse dieser Schicht 1 bis 15 Gew.-% an Polyamidelastomer enthält; und
3. Einsatz eines Polyamidelastomeren, ausgewählt aus Polyetheresteramid und Polyetheramid, als Polyamidkomponente in der Formmasse der Schicht gemäß c) derart, dass die Formmasse dieser Schicht 1 bis 25 Gew.-% an Polyamidelastomer enthält,
wobei die Prozentangaben unter 1., 2. und 3. auf die jeweilige Formmasse bezogen sind.

2. Folie gemäß Anspruch 1,
**dadurch gekennzeichnet, dass**
• die Schichten gemäß a) und c) eine Dicke von 15 bis100 µm besitzen und
• die Schicht gemäß b) eine Dicke von 100 bis 500 µm besitzt.

3. Verwendung einer Folie gemäß einem der vorhergehenden Ansprüche als Rückabdeckung eines photovoltaischen Moduls, wobei die Schicht gemäß a) mit der Siegelschicht, in die die Solarzelle eingebettet ist, verbunden wird.

4. Photovoltaisches Modul, das die Folie gemäß einem der Ansprüche 1 und 2 als Rückabdeckung enthält, wobei die Schicht gemäß a) mit der Siegelschicht, in die die Solarzelle eingebettet ist, verbunden ist.

## Claims

1. Film comprising the following layers:
a) a first outer layer of a moulding composition comprising a polyamide content of at least 35% by weight, based on the overall moulding composition,
b) a middle layer of a moulding composition comprising at least 50% by weight, based on the overall moulding composition, of a polymer fraction consisting of the following components:
I. 30 to 95 parts by weight of polyamide and
II. 5 to 70 parts by weight of polyolefin,
where the sum of the parts by weight adds up to 100, and
c) a second outer layer of a moulding composition comprising a polyamide content of at least 35% by weight, based on the overall moulding composition, where the layers according to a), b) and c) directly follow one another and where adhesion of the film composite is modified by a measure selected from
1. use of a polyamide elastomer selected from polyetheresteramide and polyetheramide as the polyamide component in the layer according to a), such that the moulding composition of this layer contains 1 to 25% by weight of polyamide elastomer;
2. use of a polyamide elastomer selected from polyetheresteramide and polyetheramide as the polyamide component in the moulding composition of the layer according to b) such that the moulding composition of this layer contains 1 to 15% by weight of polyamide elastomer; and
3. use of a polyamide elastomer selected from polyetheresteramide and polyetheramide as the polyamide component in the moulding composition of the layer according to c) such that the moulding composition of this layer contains 1 to 25% by weight of polyamide elastomer,
where percentages under 1., 2. and 3. are based on the respective moulding composition.

2. Film according to Claim 1,
**characterized in that**
• the layers according to a) and c) have a thickness of 15 to 100 µm and
• the layer according to b) has a thickness of 100 to 500 µm.

3. Use of a film according to either of the preceding claims, as a back cover of a photovoltaic module, with bonding of the layer according to a) to the sealing layer into which the solar cell has been embedded.

4. Photovoltaic module comprising the film according to either of Claims 1 and 2 as a back cover, with bonding of the layer according to a) to the sealing layer into which the solar cell has been embedded.

## Revendications

1. Feuille, qui contient les couches suivantes :
a) une première couche extérieure en un matériau de moulage qui contient une fraction de polyamide d'au moins 35 % en poids, par rapport à l'ensemble du matériau de moulage,
b) une couche intermédiaire en un matériau de moulage qui contient au moins 50 % en poids, par rapport à l'ensemble du matériau de moulage, d'une fraction de polymère constituée par les composants suivants :
I. 30 à 95 parties en poids de polyamide et
II. 5 à 70 parties en poids de polyoléfine,
la somme des parties en poids étant de 100, ainsi que
c) une seconde couche extérieure en un matériau de moulage qui contient une fraction de polyamide d'au moins 35 % en poids, par rapport à l'ensemble du matériau de moulage,
les couches selon a), b) et c) étant directement superposées et une modification de l'adhérence du composite de feuilles ayant lieu par une mesure, qui est choisie parmi
1. l'utilisation d'un élastomère de polyamide, choisi parmi un amide de polyétherester et un amide de polyéther, en tant que composant polyamide dans la couche selon a), de sorte que le matériau de moulage de cette couche contienne 1 à 25 % en poids d'un élastomère de polyamide ;
2. l'utilisation d'un élastomère de polyamide, choisi parmi un amide de polyétherester et un amide de polyéther, en tant que composant polyamide dans le matériau de moulage de la couche selon b), de sorte que le matériau de moulage de cette couche contienne 1 à 15 % en poids d'un élastomère de polyamide ; et
3. l'utilisation d'un élastomère de polyamide, choisi parmi un amide de polyétherester et un amide de polyéther, en tant que composant polyamide dans le matériau de moulage de la couche selon c), de sorte que le matériau de moulage de cette couche contienne 1 à 25 % en poids d'un élastomère de polyamide ;
les données de pourcentage selon 1., 2. et 3. se rapportant au matériau de moulage respectif.

2. Feuille selon la revendication 1, **caractérisée en ce que**
- les couches selon a) et c) présentent une épaisseur de 15 à 100 µm, et
- la couche selon b) présente une épaisseur de 100 à 500 µm.

3. Utilisation d'une feuille selon l'une quelconque des revendications précédentes en tant que couverture arrière d'un module photovoltaïque, la couche selon a) étant reliée avec la couche de scellement dans laquelle la cellule solaire est incorporée.

4. Module photovoltaïque, qui contient la feuille selon l'une quelconque des revendications 1 et 2 en tant que couverture arrière, la couche selon a) étant reliée avec la couche de scellement dans laquelle la cellule solaire est incorporée.
